# EUROPEAN PATENT SPECIFICATION

(11) **EP 1 120 658 B1**
(45) Date of publication and mention of the grant of the patent: **20.12.2006**
(21) Application number: 01200188.9
(22) Date of filing: 19.01.2001
(51) Int. Cl.: G01R 11/04

(54) **Electricity meter measurement circuitry**
Schaltungsanordnung für Elektrizitätszähler
Appareillage de mesure pour compteurs électriques

(30) Priority: 21.01.2000 GB 0001271
(43) Date of publication of application: 01.08.2001
(73) Proprietor: Landis+Gyr Limited, Stockport Cheshire SK3 0RT (GB)
(72) Inventor: Paxton-White, Michael, Halifax, West Yorkshire HX6 4DT (GB)
(74) Representative: Humphrey-Evans, Edward John

(56) References cited:
- EP-A- 0 347 974
- US-A- 4 713 610
- US-A- 5 068 962

## Description

The present invention relates to improvements in or relating to metering and is more particularly concerned with electricity meter measurement circuitry.

In electricity meters, measuring elements are provided in the current path through the meter from which measurements relating to current flow in the current path. Each measuring element is connected to a measurement circuit so that the measurement circuit can determine the information relating to current flow. Normally, the measurement circuit is mounted on a rigid printed circuit board (PCB) together with other electronic components which is removed from the measuring element, and the connections between the measurement circuit and the measuring element can be messy and complex if a number of connections need to be made. Moreover, such connections tend to pick up electrical noise which may comprise a source of error in the measurement.

However, with the current trend towards miniaturising circuitry within electricity meters, it is often difficult to make effective connection between the measuring element and the measurement circuitry due to their small size and compact layout.

US-A-5 068 962 (GEC) teaches of a method of fabricating an energy meter; EP-A-347 974 (Teikoku Tsushin) describes a mount for electronic parts; US-A-4 713 610 (Westinghouse Electric) teaches of an electric meter with an improved sensing head assembly.

It is therefore an object of the present invention to provide a method of allowing the circuitry to be connected together without using conventional wiring, but, at the same time, allowing the components of the meters to be made smaller and cheaper.

It is a further object of the present invention to simplify the connections between the PCB and the measuring element.

In accordance with one aspect of the present invention, there is provided an electricity meter having a current path therethrough, the meter comprising:-a measuring element located in the current path; a measurement circuit connected to the measuring element for receiving an input therefrom and for processing the input to providing an output; and flexible circuit means connecting the measuring element to the measurement circuit, at least one component of the measurement circuit being located on the flexible circuit means adjacent the measuring element, the flexible circuit means providing reduction in distance between the measuring element and the measuring circuit thereby reducing the effect of electrical noise and any subsequent error.

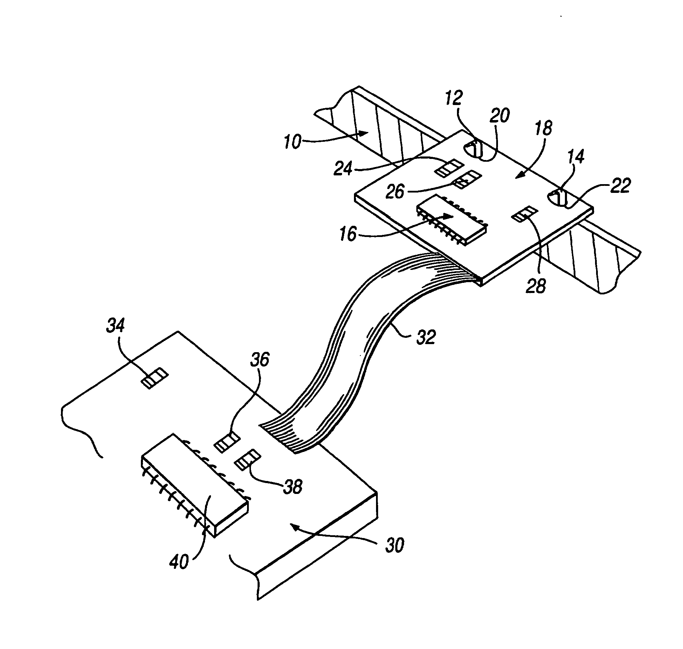

For a better understanding of the present invention, reference will now be made, by way of example only, to the accompanying drawing, the single Figure of which illustrates a flexible circuit arrangement in accordance with the present invention.

Although the present invention will be described with reference to an electricity meter, it will readily be appreciated that it can also be utilised in any other device where space and size are important factors.

In the Figure, a portion of the current path 10 through an electricity meter is shown. Located in the path 10 is a measuring element (not shown) which has a higher resistivity than that the rest of the path 10. The measuring element has projections 12, 14 for connecting to a measurement circuit 16. In accordance with the present invention, the measurement circuit 16 is mounted on a flexible circuit 18 which is located adjacent the measuring element and the path 10. The flexible circuit 18 has two connector portions 20, 22 in the form of holes which engage the projections 12, 14 on the measuring element and which effectively connect the measurement circuit 16 with the measuring element in the current path 10. Other components 24, 26, 28 may also be provided on the flexible circuit 18.

The flexible circuit 18 is connected to a rigid printed circuit board (PCB) 30 by means of an electrical ribbon connector 32. The PCB 30 has a plurality of components 34, 36, 38, 40 mounted thereon for operational control of the electricity meter (not shown) of which it forms a part.

In accordance with the present invention, use of the flexible circuit 18 provides for reduction of the connection length between the measuring element and the measurement circuit 16. This reduction in connection length provides improved measurement accuracy and allows for miniaturisation of the system.

Although the present invention has been described as having a single-component measurement circuit 16 mounted on the flexible circuit 18, it will be appreciated that the measurement circuit may comprise a plurality of electrically operated components which are connected together in such a way that they can utilise the output from the measurement device and convert it into a similar or other output form which is representative of the input from the measuring element. One or more of the electrically operated components may be mounted on the flexible circuit with others of the electrically operated components being mounted on the PCB 30.

The output from the measurement circuit on the flexible circuit may either be further processed or used directly by other circuitry not connected on the PCB. Furthermore, if the measurement circuit on the flexible circuit can convert all of the input from the measuring element into a suitable output form, then they may be no requirement for circuitry which is not mounted on the flexible circuit. In this way, all of the measurement and conversion is provided by circuitry mounted on the flexible circuit.

By mounting at least some of the electrically operated components on the flexible circuit, they may be used in such a way that the construction of an electricity meter may be made smaller and/or simpler and/or cheaper.

Furthermore, the use of a flexible circuit can simplify the connection between the measuring element and the measurement circuit whilst allowing use to be made of existing electricity meter designs where discrete wires were previously utilised.

Moreover, the use of a flexible circuit with some or all of the measurement circuit mounted thereon allows systems to be built with a reduced distance between the measuring element and the measurement circuit.

The measuring element may comprise a shunt for current measurement, a current transformer, a voltage transformer or a Hall effect current sensor. The exact nature of the measuring element is not critical to the present invention.

## Claims

1. An electricity meter having a current path (10) therethrough, the meter comprising:-
a measuring element located in the current path; and
a measurement circuit (16) connected to the measuring element for receiving an input therefrom and for processing the input to provide an output;
**characterized in that** a flexible circuit means (18) connects the measuring element to the measurement circuit,
at least one component of the measurement circuit being located on the flexible circuit means adjacent the measuring element, the flexible circuit means providing a reduction in distance between the measuring element and the measuring circuit whereby to reduce the effect of electrical noise and any subsequent error.

2. A meter according to claim 1, wherein the measurement circuit comprises a single component (16) which is located on the flexible circuit means.

3. A meter according to claim 1 or 2, further comprising a circuit board connected to the flexible circuit means and carrying electronic components (34, 36, 38 & 40) for controlling the operation of the meter.

4. A meter according to claim 3, wherein the flexible circuit board is connected to the measurement circuit board by a ribbon connector.

5. A meter according to any one of the preceding claims, wherein the flexible circuit means further comprises mounting means (12,14) for mounting at least one component of the measurement circuit thereon.

## Patentansprüche

1. Ein Stromzähler mit einem **dadurch** führenden Strompfad (10) bestehend aus:-
einem im stromführenden Pfad befindlichen Meßelement; und
einem mit dem Meßelement verbundenen Meßkreis (16) zum Empfang eines Eingangssignals davon und zur Verarbeitung dieses Eingangssignals um ein Ausgangssignal bereitzustellen;
**dadurch gekennzeichnet, daß** eine flexible Leiterplatte (18) das Meßelement mit dem Meßkreis verbindet,
und wobei mindestens ein Bauteil des Meßkreises auf der flexiblen Leiterplatte neben dem Meßelement angebracht ist und **dadurch** die flexible Leiterplatte den Abstand zwischen Meßelement und Meßkreis verringert und somit die Wirkung der elektrischen Störsignale und Folgefehler reduziert.

2. Ein Zähler gemäß Anspruch 1, wobei der Meßkreis aus einem einzelnen Bauteil (16) besteht das auf einer flexiblen Leiterplatte untergebracht ist.

3. Ein Zähler gemäß Anspruch 1 oder 2, im weiteren aus einer Leiterplatte bestehend das mit der flexiblen Leiterplatte verbunden ist und die elektronischen Bauteile (34, 36, 38 & 40) zur Steuerung des Betriebs des Zählers trägt.

4. Ein Zähler gemäß Anspruch 3, wobei die flexible Leiterplatte mit der Meßkreisplatine über einen Bandkabelstecker verbunden ist.

5. Ein Zähler gemäß den vorherigen Ansprüchen, wobei die flexible Leiterplatte im weiteren Befestigungsmittel (12, 14) zur Befestigung von wenigstens einem Bauteil auf dem Meßkreis aufweist.

## Revendications

1. Un compteur électrique traversé par un parcours de courant (10), le compteur comprenant:
un élément de mesure placé dans le parcours du courant; et
un circuit de mesure (16) relié à l'élément de mesure pour recevoir une entrée venant de celui-ci et pour traiter l'entrée pour fournir une sortie; **caractérisé en ce qu'**un organe de circuit flexible (18) relie l'élément de mesure au circuit de mesure, au moins un composant du circuit de mesure étant placé sur l'organe de circuit flexible adjacent à l'élément de mesure, l'organe de circuit flexible fournissant une réduction de distance entre l'élément de mesure et le circuit de mesure, réduisant ainsi les effets du brouillage et de toute autre erreur ultérieure.

2. Un compteur électrique selon la revendication 1, **caractérisé en ce que** le circuit de mesure comprend un seul composant (16) qui est placé sur l'organe de circuit flexible.

3. Un compteur selon la revendication 1 ou 2, comprenant de plus une plaquette de circuit reliée à l'organe de circuit flexible et porteuse des éléments électroniques (34, 36, 38 et 40) pour contrôler le fonctionnement du compteur.

4. Un compteur selon la revendication 3, **caractérisé en ce que** la plaquette de circuit flexible est reliée à la plaquette du circuit de mesure par un ruban connecteur.

5. Un compteur selon l'une quelconque des revendications précédentes, **caractérisé en ce que** l'organe de circuit flexible comprend encore un organe de montage (12, 14) pour mettre en place au moins un composant du circuit de mesure dessus.
